# DEMANDE DE BREVET EUROPEEN

(11) **EP 1 571 568 A1**
(43) Date de publication de la demande: **07.09.2005**
(21) Numéro de dépôt: 05290444.8
(22) Date de dépôt: 25.02.2005
(51) Int. Cl.: G06F 17/50

(54) **Procédé automatisé d'insertion hiérarchique et sélective de surfaces factices dans le dessin physique d'un circuit intégré multicouche**

(30) Priorité: 27.02.2004 FR 0402011
(71) Demandeur: BULL S.A., 78430 Louveciennes (FR)
(72) Inventeur: Zorilla, Marta, 78330 Fontenay Le Fleury (FR); Blanchard, Vivian, 78100 Saint Germain en Laye (FR)
(74) Mandataire: Debay, Yves

(57) **Abrégé**

La présente invention concerne un procédé automatisé d'insertion de surfaces factices (95) dans les différentes couches du dessin (121) physique des circuits intégrés multicouches, permettant le respect des règles de densité de surface imposées par les constructeurs, caractérisé, d'une part, en ce qu'il est sélectif des méthodes employées pour le dessin des blocs (30) et des unités (2) du circuit et, d'autre part, en ce qu'il respecte la hiérarchie du dessin physique, par un traitement individuel des blocs (30) et de leur routage (31) d'interconnexion et un traitement individuel des unités (2) et de leur routage (22) d'interconnexion, en définissant des motifs de surfaces factices (95), après calcul de la densité de surface dans une pluralité de fenêtres (81, 82, 83) successives de contrôle de densité sur toutes les couches du circuit intégré.

## Description

La présente invention concerne le domaine des semi-conducteurs et en particulier des circuits intégrés multicouches, de type très large échelle (VLSI pour l'anglais Very Large Scale Integration) ou spécifiques des applications (ASIC pour l'anglais Application-Specific Integrated Circuit). Cette invention s'applique également au domaine du dessin assisté par ordinateur (DAO) et en particulier le dessin automatisé des surfaces des circuits intégrés. La présente invention concerne un procédé permettant l'insertion automatique de surfaces factices dans les différentes couches des circuits intégrés multicouches, de façon à respecter les règles de densité de surfaces imposées par les constructeurs de semi-conducteurs.

Les procédés semi-conducteurs de fabrication des circuits intégrés exigent que la densité de surface de chaque couche se trouve dans une plage déterminée et que sa distribution soit la plus homogène possible dans chacune des couches constituant le circuit intégré multicouche. Le processus classique de fabrication des circuits intégrés fait appel à des superpositions de couches successives, par des masquages successifs des tranches de silicium et des opérations de photogravure, de diffusion, de métallisation, de polissage, de dopage, etc. La superposition des différentes couches du circuit intégré permet d'implémenter des fonctions logiques élémentaires. Le dessin physique des éléments constituant un circuit intégré introduit donc des variations de la surface sur l'ensemble du circuit. L'introduction, entre les éléments constitutifs du dessin physique du circuit intégré, de surfaces, dites factices, est donc nécessaire pour homogénéiser la densité de surface d'une couche donnée du circuit intégré et permettre la fabrication de la couche supérieure. Ces surfaces sont dites factices (« dummy », en anglais) car elles ne participent à aucun des éléments du circuit intégré. Elles sont également appelées structures de remplissage (« filler », en anglais). Pour permettre aux concepteurs de se conformer aux règles de densité de surface imposées, le constructeur définit généralement la forme, les tailles limites des surfaces factices qui devront être insérées, ainsi que l'espacement limite des surfaces factices entre elles et les zones d'exclusion des surfaces factices, correspondant à l'espace autour des éléments du dessin physique où aucune surface ne doit être présente.

Il est connu dans l'art antérieur des procédés d'insertion de surfaces factices qui traitent le circuit intégré de façon globale, en définissant un motif et en l'insérant dans les espaces vides du circuit intégré. En général, des carrés ou des rectangles sont insérés dans les espaces vides avec un espacement optimisé pour respecter la densité de surface exigée du circuit. Ces procédés permettent d'homogénéiser la densité de surface sans imposer de changement dans l'arrangement du dessin physique du circuit. Cependant, cette solution présente plusieurs inconvénients. Avec ce type de méthode, des surfaces factices sont insérées même dans des régions où la densité était acceptable et la densité peut donc dépasser, dans certaines régions, la densité maximale acceptée par le constructeur, ce qui oblige à modifier le traitement réalisé. Il arrive également que l'on ne puisse pas atteindre la densité minimum exigée car le dessin physique est tel qu'il est impossible d'introduire des surfaces factices. Dans ce cas, le dessin étant complètement terminé, aucune modification locale n'est possible et le dessin complet doit être revu. D'autre part, la performance du circuit ne peut pas être contrôlée avec ce type de méthode et la dégradation des performances du circuit intégré produite par les surfaces factices peut s'avérer trop importante. De plus, l'ajout d'un nombre élevé d'éléments conduit à générer des fichiers de dessin du circuit intégré trop grands. Enfin, ces procédés nécessitent un temps de mise au point trop important jusqu'à trouver le motif qui donne le meilleur résultat. Les deux derniers inconvénients énoncés sont d'autant plus graves que le nombre de couches utilisées et la taille du circuit augmentent.

Les constructeurs fournissent généralement un outil de contrôle des règles du dessin (DRC, pour l'anglais Design Rules Control) permettant aux concepteurs de vérifier si leurs circuits intégrés respectent les règles de dessin et de densité exigées. Cet outil réalise un contrôle de la densité de surface sur chacune des couches du circuit intégré, grâce à un calcul de la densité de surface dans des fenêtres de contrôle de densité, dont les formes et les dimensions sont optimisées par les constructeurs.

Le dessin de circuits intégrés complexes et à grand nombre de transistors est réalisé de façon hiérarchique. Le circuit est divisé en unités interconnectées, chaque unité étant divisée en blocs également interconnectés. Le dessin physique des blocs peut être réalisé selon deux méthodes différentes. La première, connue sous le nom de méthode des cellules standards (« standard cell », en anglais) consiste à assembler et interconnecter des cellules provenant d'une bibliothèque de cellules prédéfinies, où chaque cellule correspond à une porte logique. Les blocs ainsi réalisés sont constitués d'un ensemble de plusieurs cellules placées selon des rangées et interconnectées en général par des canaux situés entre les rangées. La seconde, connue comme méthode des cellules personnalisées (« custom cell », en anglais) consiste à dessiner des cellules spécialement taillées selon les caractéristiques électriques traitées. Les interconnexions des cellules de ce type se font à l'intérieur de la cellule même. Les blocs obtenus par combinaison de cellules de ce type sont donc généralement plus complexes et nécessitent donc un traitement plus complexe pour l'insertion de surfaces factices dans les différentes couches du circuit.

Les interconnexions entre les blocs formant les unités et les interconnexions entre les unités formant le dessin physique d'un circuit sont réalisées grâce à un système de routage automatique spécifique. Les différentes méthodes peuvent utiliser de règles de dessin différentes, mais toutes doivent respecter les limites imposées par le constructeur. Il serait donc souhaitable de disposer d'un procédé sélectif de la méthode de dessin utilisée et respectueux des règles des constructeurs. De plus, les procédés connus de l'art antérieur ne respectent généralement pas la hiérarchie résultant du dessin physique et nécessitent le traitement intégral du dessin à chaque modification d'un de ses blocs. Un procédé sélectif de la méthode de construction et respectant la hiérarchie du dessin permettrait de ne traiter sélectivement que le bloc modifié, en ne tenant compte que de la méthode utilisée pour le dessin du bloc en question et permettrait la réutilisation des différents blocs ou des unités, avec leurs surfaces factices optimisées, dans d'autres circuits intégrés.

Un autre problème dans le dessin des circuits intégrés, dont l'importance croit au fur et à mesure que les dimensions critiques diminuent, est le couplage entre liaisons métalliques voisines circulant sur la même couche ou entre celles qui se croisent car elles circulent sur des niveaux métalliques différents. Une façon d'améliorer la performance du circuit est de définir des règles de dessin pour les liaisons métalliques avec des espacements plus grand que le minimum permis par la technologie, ce qui ferait diminuer les phénomènes de couplage de voisinage. La densité maximum de remplissage par le dessin, dans ces conditions, est inférieure ou égale à la densité minimale admise par le constructeur. Mais l'ajout de surfaces factices sera alors nécessaire et celles-ci participeront au couplage avec les liaisons métalliques. L'insertion de surfaces factices autour des liaisons métalliques de routage des circuits est donc une étape importante pour les performances du circuit intégré.

Il est connu dans l'art antérieur des procédés de remplissage des espaces vides d'un circuit intégré utilisant une méthode de « masquage inverse » (« reverse mask », en anglais). Les négatifs des masques utilisés pour le dessin physique sont utilisés pour protéger les éléments constitutifs du circuit et exposer les espaces vides, qui sont alors remplis de façon homogène. Cette méthode présente un surcoût énorme et des risques de défectuosité beaucoup trop importants à cause des problèmes de couplage dus à la proximité entre les surfaces factices et les éléments constitutifs du circuit.

Tous les procédés de dessin de circuit intégré doivent donc respecter les règles de densité de surface exigées par les constructeurs et les différentes contraintes imposées par les problèmes de couplage dans les circuits. Le nombre d'éléments ajoutés devra être le plus faible possible et les procédés éviteront dans la mesure du possible le couplage entre les liaisons métalliques et les surfaces ajoutées, en respectant les zones d'exclusion. Les concepteurs, pour optimiser les performances de leur circuit, choisiront également d'éviter la superposition des surfaces factices avec des liaisons métalliques, circulant sur un autre niveau mais avec la même orientation. Dans ce contexte, il est intéressant de définir un mode d'insertion de surfaces factices qui tienne compte des différentes méthodes de dessin, de leur hiérarchie et des contraintes imposées par les constructeurs et les concepteurs. Une façon de faciliter le traitement serait d'utiliser les fenêtres de contrôle de densité spécifiées par les constructeurs. La densité de surface calculée permettrait d'insérer sélectivement des surfaces factices seulement dans les zones à faible densité. Les surfaces factices devront être insérées en respectant les zones d'exclusion et un espacement limite des surfaces factices entre elles.

La présente invention a pour but de répondre aux exigences des procédés de fabrication de circuits intégrés et de pallier certains inconvénients de l'art antérieur en proposant un procédé automatisé d'insertion de surfaces factices dans le dessin physique des circuits intégrés qui est sélectif de la méthode employée pour le dessin physique du circuit intégré et qui permet à la fois de respecter la hiérarchie du dessin physique et d'homogénéiser la densité de surface dans chacune des couches du circuit intégré, selon les règles de densité de surface imposées par les constructeurs, en minimisant la capacité de couplage entre les surfaces factices ajoutées et les éléments du dessin physique du circuit intégré.

Ce but est atteint par un procédé automatisé d'insertion de surfaces factices dans les différentes couches du dessin physique des circuits intégrés multicouches, organisés en unités interconnectées et contenant des blocs interconnectés et constitués de cellules interconnectées, mis en oeuvre par un système de conception de circuits intégrés, caractérisé en ce qu'il consiste en un traitement automatisé, couche par couche, d'un dessin de circuit intégré multicouches stocké dans des moyens de mémorisation du système de conception, par une insertion sélective de motifs de surfaces factices selon une hiérarchie d'insertion respectant la hiérarchie du dessin des circuits intégrés grâce à un traitement individuel des blocs et de leur routage d'interconnexion et un traitement individuel des unités et de leur routage d'interconnexion, les motifs étant établis sélectivement en fonction des méthodes employées pour le dessin des blocs du circuit intégré.

Selon une autre particularité, les motifs de surfaces factices établis sélectivement, en fonction des méthodes employées pour le dessin des blocs du circuit intégré, sont déterminés grâce à des moyens de calcul géométrique du système de conception et grâce à des règles de définition des motifs des surfaces factices, stockées dans les moyens de mémorisation du système de conception, ces motifs étant définis par une forme, une taille, une orientation et des zones d'exclusion des surfaces factices, ainsi que par un espacement des surfaces factices entre elles.

Selon une autre particularité, l'insertion sélective de motifs de surfaces factices, selon une hiérarchie d'insertion respectant la hiérarchie du dessin des circuits intégrés, est réalisée grâce à l'intervention d'un utilisateur, dit concepteur, qui définit, à l'aide de moyens de saisie de commandes du système de conception, les blocs et/ou les unités à traiter dans le dessin du circuit, ainsi que la méthode employée pour le dessin des blocs.

Selon une autre particularité, l'insertion sélective de motifs de surfaces factices, selon une hiérarchie d'insertion respectant la hiérarchie du dessin des circuits intégrés, est réalisée de façon automatisée grâce à des moyens de reconnaissance de la hiérarchie du dessin et des moyens de reconnaissance des méthodes de dessin, implémentés dans le système de conception et permettant une définition automatique des blocs et/ou des unités à traiter dans le dessin du circuit, ainsi que de la méthode employée pour leur dessin, au lieu de nécessiter l'intervention de l'utilisateur.

Selon une autre particularité, le procédé comporte une étape de détermination de zones à faible densité de surface dans lesquelles des surfaces factices doivent être insérées, réalisée grâce à un calcul de la densité de surface dans chacune des couches du circuit, dans des fenêtres de contrôle de densité dont la forme et les dimensions sont établies selon les fenêtres de contrôle de densité définies par les constructeurs de semi-conducteurs et stockées dans des moyens de mémorisation du système de conception de circuits intégrés, ce calcul étant réalisé par des moyens de calcul de densité implémentés dans le système de conception de circuits intégrés et permettant de ne traiter que les fenêtres dont les densités ne correspondent pas à la densité exigée par les constructeurs et de minimiser le nombre d'éléments ajoutés dans le circuit.

Selon une autre particularité, la hiérarchie d'insertion des surfaces factices, la détermination des zones à faible densité de surface dans lesquelles des surfaces factices doivent être insérées et les règles de définition des motifs des surfaces factices, résultent en un traitement du dessin physique du circuit intégré selon les étapes suivantes :
- insertion de surfaces factices dans les zones à faible densité de surface de chacun des blocs du dessin, indépendamment les uns des autres, en fonction de la méthode employée pour leur dessin et leur routage spécifique ;
- traitement du routage entre les blocs et combinaison avec les résultats obtenus pour chaque bloc, pour obtenir une unité homogène correspondant au dessin d'une unité avec ses surfaces factices insérées ;
- éventuel retrait des surfaces factices se trouvant à la frontière d'un bloc et ne respectant pas les zones d'exclusion, grâce à des moyens de vérification des zones d'exclusion.
- combinaison entre eux des résultats obtenus pour chacune des unités, puis décision, en fonction de la taille et de la complexité du circuit, de l'étape de traitement à réaliser sur le routage entre les unités parmi soit une étape d'insertion de surfaces factices dans les zones à faible densité de surface au sein de la combinaison des unités homogènes, soit une étape d'insertion de surfaces factices dans les zones de routage entre les unités homogènes combinées, grâce à une étape préalable de masquage des zones définies par le concepteur.
- combinaison du résultat des unités homogènes combinées avec le résultat du traitement du routage entre les unités, puis éventuel retrait des surfaces factices se trouvant à la frontière d'une unité et ne respectant pas les zones d'exclusion, grâce à des moyens de vérification des zones d'exclusion, pour obtenir un motif de surfaces factices pour le circuit intégré complet.

Selon une autre particularité, la hiérarchie d'insertion des surfaces factices impose que les zones à faible densité de surface traitées en premier correspondent aux fenêtres dont la densité est nulle, les règles de définition des motifs des surfaces factices imposant, dans ces fenêtres à densité nulle, l'insertion de surfaces factices selon la même orientation que celle du routage de la couche en cours de traitement, avec une dimension maximum correspondant aux dimensions de la fenêtre de contrôle de densité, une dimension minimum correspondant à la dimension minimum définie par les constructeurs et un espacement entre les surfaces défini de façon à obtenir une densité légèrement supérieure au minimum exigé par les constructeurs.

Selon une autre particularité, la hiérarchie d'insertion des surfaces factices impose que les zones à faible densité de surface traitées en second correspondent aux fenêtres dont la densité est encore inférieure au minimum exigé par les constructeurs, les règles de définition des motifs des surfaces factices imposant, dans ces fenêtres à densité insuffisante, l'insertion de surfaces factices similaires aux liaisons métalliques du routage, avec une grande zone d'exclusion, en interdisant la superposition des surfaces factices avec des liaisons métalliques circulant avec la même orientation sur une autre couche.

Selon une autre particularité, les règles de définition des motifs des surfaces factices comportent un ordre de priorité dans le choix des contraintes à imposer à ces motifs parmi les contraintes de forme, de taille, d'orientation et des zones d'exclusion des surfaces factices à insérer, cet ordre de priorité étant mémorisé dans les moyens de mémorisation du système de conception de circuits intégrés et permettant d'autoriser, si nécessaire, la levée des contraintes, unes à unes, selon les étapes suivantes dont les itérations permettent de définir les motifs des surfaces factices à insérer :
- autorisation de la superposition des surfaces factices avec des liaisons métalliques circulant avec la même orientation sur une autre couche ;
- autorisation de l'insertion de surfaces factices avec une orientation perpendiculaire à l'orientation de la couche dans laquelle elles sont insérées ;
- autorisation de la réduction des zones d'exclusion des surfaces factices insérées selon la même orientation que celle de la couche ;
- autorisation de la réduction des zones d'exclusion des surfaces factices insérées selon une orientation perpendiculaire à celle de la couche dans laquelle elles sont insérées.

Selon une autre particularité, l'insertion sélective des motifs des surfaces factices, en fonction de la méthode employée pour dessin des blocs et les règles de définition des motifs des surfaces factices permettent, pour les régions dessinées avec des cellules standard, de définir des surfaces factices de petite taille, rapprochées entre elles et avec des zones d'exclusion restreintes et d'autoriser la superposition des surfaces factices avec des liaisons métalliques circulant avec la même orientation sur une autre couche, le traitement des régions dessinées avec des cellules personnalisées nécessitant le respect complet de l'ordre de priorité dans le choix des contraintes à imposer, avec une itération importante des étapes définissant l'ordre de priorité des contraintes, résultant en une grande variété de motifs des surfaces factices.

Selon une autre particularité, le procédé selon l'invention permet le traitement de dessins physiques non hiérarchiques grâce la détermination de des fenêtres à traiter en priorité selon leur densité, grâce aux règles de définition des motifs des surfaces factices à insérer et éventuellement grâce à l'étape de masquage de zones définies par le concepteur.

Selon une autre particularité, le procédé est mis en oeuvre par l'exécution, par le système de conception de circuits intégrés, d'un outil logiciel de dessin assisté par ordinateur exécutant des macros permettant les itérations des différentes étapes du procédé, résultant en la définition sélective des motifs des surfaces factices et leur insertion dans les couches successives du circuit intégré.

Selon une autre particularité, les zones d'exclusion des surfaces factices utilisées lors de la mise en oeuvre du procédé ont des dimensions supérieures à celles définies par les constructeurs, de façon à ce que lorsque les contraintes de taille des zones d'exclusion sont toutes levées, les zones d'exclusion obtenues restent de taille supérieure ou égale à la taille des zones d'exclusion définies par les constructeurs.

Selon une autre particularité, le procédé peut être limité par l'utilisateur de façon à ne traiter que certains blocs ou que certaines unités, pour permettre le traitement en parallèle de différentes portions du circuit dans plusieurs systèmes de conception de circuits intégrés, afin d'accélérer le traitement du dessin complet du circuit, le traitement séparé des blocs et/ou des unités permettant une modification ultérieure sélective de ces éléments du circuit individuellement et leur éventuelle réutilisation dans le cas de la présence d'un élément identique dans une autre région du circuit ou dans un autre circuit intégré.

Un autre but de l'invention est de répondre aux exigences des procédés de fabrication de circuits intégrés et de pallier certains inconvénients de l'art antérieur en proposant un système de conception de circuits intégrés permettant la mise en oeuvre du procédé selon l'invention, grâce à l'insertion de surfaces factices dans le dessin physique des circuits intégrés pour homogénéiser la densité de surface dans chacune des couches du circuit intégré, selon les règles de densité de surface imposées par les constructeurs, en respectant à la fois la hiérarchie du dessin physique et la méthode employée pour le dessin physique du circuit intégré, tout en minimisant la capacité de couplage entre les surfaces factices ajoutées et les éléments du dessin physique du circuit intégré

Ce but est atteint par un système de conception de circuits intégrés permettant la mise en oeuvre du procédé selon l'invention grâce à l'exécution de macros dans des outils logiciels de dessin assisté par ordinateur et comportant des moyens d'affichage et des moyens de saisie de commandes par l'utilisateur, caractérisé en ce qu'il comporte des moyens de mémorisation, des moyens de calcul, des moyens de traitement et des moyens de vérification des zones d'exclusion.

Selon une autre particularité, les moyens de calcul comportent, en outre, des moyens de calcul de densité et des moyens de calcul géométrique.

Selon une autre particularité, les moyens de mémorisation contiennent, en outre, des informations concernant le dessin physique du circuit intégré dans lequel les surfaces factices doivent être insérées, la forme et les dimensions des fenêtres de contrôle de densité définies par les constructeurs de semi-conducteurs, les règles de définition des motifs des surfaces factices permettant la définition des motifs de surfaces factices selon les densités de surface des différentes fenêtres, les différentes méthodes de dessin des blocs et l'ordre de priorité défini par le concepteur du circuit intégré pour le choix des contraintes à imposer aux motifs des surfaces factices à insérer, toutes ces informations étant accessibles aux moyens de traitement du système de conception de circuits intégrés pour les prendre en compte lors de l'exécution des macros permettant la définition des motifs des surfaces factices et leur insertion dans les couches successives du circuit intégré.

Selon une autre particularité, le système de conception comporte également des moyens de reconnaissance de la hiérarchie du dessin et des moyens de reconnaissance des méthodes de dessin, de façon à ce que la définition des blocs et/ou des unités à traiter dans le dessin du circuit, ainsi que de la méthode employée pour leur dessin soit réalisée de façon automatisée par le système sans nécessiter l'intervention de l'utilisateur.

D'autres particularités et avantages de la présente invention apparaîtront plus clairement à la lecture de la description ci-après, faite en référence aux dessins annexés, dans lesquels :
- la figure 1 représente un schéma des étapes du traitement réalisé par le procédé mis en oeuvre selon l'invention, en fonction des méthodes de dessin connues de l'art antérieur,
- la figure 2 représente un schéma du déroulement de l'algorithme d'insertion de surfaces factices en fonction des fenêtres de densité.
- les figures 3a et 3b représentent un schéma du dessin physique d'une couche d'un circuit intégré, telle qu'il est mémorisé dans des moyens de mémorisation d'un système de conception de circuits intégrés, respectivement avant et après l'insertion de surfaces factices.

La présente invention concerne un procédé permettant l'insertion de surfaces factices (95) dans le dessin (121) physique des circuits intégrés, de façon à respecter les règles de densité de surface imposées par les constructeurs de semi-conducteurs. Ce procédé utilise un outil de dessin assisté par ordinateur (D.A.O.), permettant la définition des dimensions et des positions relatives et respectives de différents polygones et de calculer la densité de surface sur une fenêtre donnée du dessin. Aucun détail ne sera donné sur de tels outils de dessin puisqu'ils ne caractérisent pas l'invention, mais constituent un environnement dans lequel l'invention peut être mise en oeuvre. L'invention se définit par l'utilisation de macros (1) qui permettent la mise en oeuvre des différentes étapes du procédé et qui sont exécutées dans l'environnement logiciel fourni par les outils de D.A.O.

Le concepteur du circuit intégré utilise un système (100) de conception de circuits intégrés selon l'invention, dans lequel est exécuté, par exemple, un outil logiciel de D.A.O. exécutant les macros (1) permettant la mise en oeuvre du procédé selon l'invention. Des moyens (110) d'affichage et des moyens (111) de saisie de commandes du système (100) de conception permettent à l'utilisateur, dit concepteur de définir certains paramètres contrôlant l'exécution automatisée des étapes du procédé selon l'invention. Le concepteur peut ainsi définir les règles de densité de surfaces imposées par les constructeurs de circuits intégrés semi-conducteurs, telle que la densité minimum exigée. Les constructeurs exigent que la densité de surface soit homogène sur toute la surface des différentes couches d'un circuit intégré et vérifient généralement cette densité de surface grâce à un outil de contrôle de règles de dessin (DRC, pour l'anglais Design Rules Control). Grâce aux moyens (111) de saisie de commandes, le concepteur pourra donc également définir la taille et la forme des fenêtres de contrôle de densité qu'il souhaite utiliser et pourra déclencher une ou plusieurs des étapes du procédé selon l'invention. Ce procédé est automatisé et le concepteur pourra paramétrer son système pour qu'il réalise l'insertion des surfaces factices (95) dans le dessin (121) physique du circuit intégré dans son intégralité, sans nécessiter l'intervention du concepteur jusqu'à obtention du résultat final. Le concepteur pourra également déclencher l'insertion de surfaces factices (95) seulement dans une partie du dessin (121) du circuit intégré, puisque le procédé mis en oeuvre respecte la hiérarchie du dessin (121) physique, en traitant individuellement chacun de ses éléments constitutifs.

Dans une variante de réalisation, le traitement intégral du circuit est réalisé grâce à l'intervention de l'utilisateur du système (100) de conception, qui définit les différents blocs (30) et/ou les unités (2) à traiter dans le dessin (121) du circuit intégré, ainsi que les méthodes utilisées pour le dessin des blocs (30). En fonction de cette hiérarchie du dessin (121) définie par l'utilisateur, le procédé réalisera le traitement des différents blocs (30) successifs et/ou des unités (2) successives du circuit, par insertion de surfaces factices (95) dans les différentes couches du circuit. En fonction des blocs et/ou des unités à traiter, le routage entre les blocs et/ou entre les unités sera traité également, l'insertion de surfaces factices dans le routage à l'intérieur des blocs étant réalisé pendant le traitement des blocs. Dans une autre variante de réalisation, le système (100) de conception comporte également des moyens (141) de reconnaissance de la hiérarchie présente dans le dessin (121) des circuits intégrés et des moyens (142) de reconnaissance des méthodes de dessin employée. Le procédé mis en oeuvre par ce système permettra alors d'insérer des surfaces factices dans toutes les couches du circuit sans nécessiter l'intervention de l'utilisateur pour définir la méthode employée pour le dessin des blocs (30) contenus dans les unités (2) du circuit.

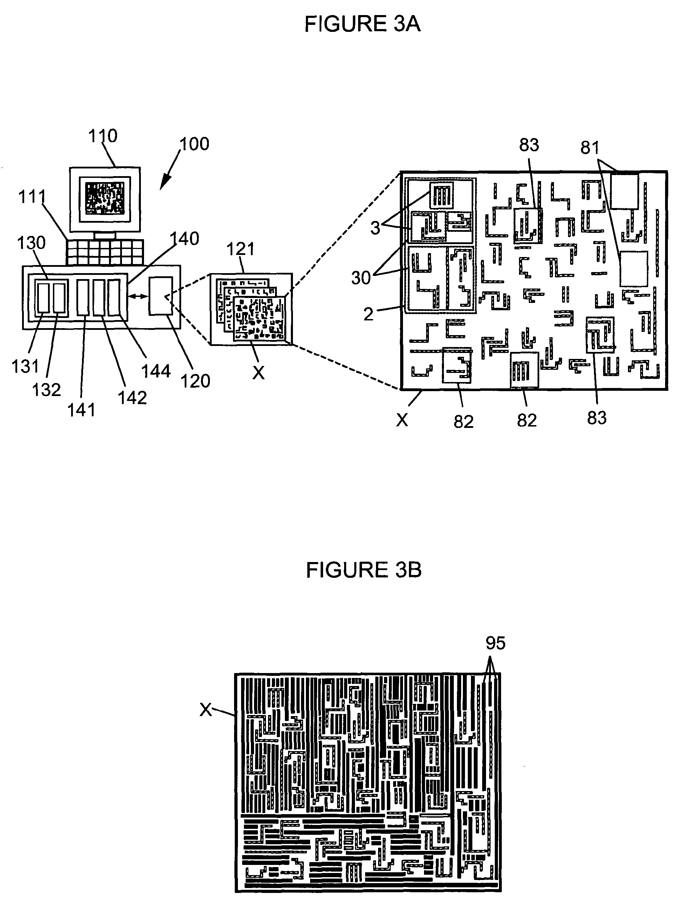

Les figure 3a et 3b représentent le schéma d'un exemple de dessin (121) physique d'un circuit intégré, telle qu'il est mémorisé dans des moyens (120) de mémorisation d'un système (100) de conception de circuits intégrés. Le schéma d'une couche (X) du dessin (121) du circuit intégré est représenté, respectivement avant et après l'insertion de surfaces factices (95). Différentes fenêtres (81, 82, 83) de contrôle de densité sont également représentées. Le procédé selon l'invention réalise un traitement du dessin (121) selon des fenêtres de contrôle de la densité de surfaces, grâce à des moyens (140) de traitement du système (100) de conception de circuits intégrés, permettant l'exécution de macros (1) dans des outils logiciels de dessin assisté par ordinateur. Les fenêtres (81) dans lesquelles la densité de surface est nulle seront traitées en priorité. Les fenêtres (82) dans lesquelles la densité de surface est inférieure au minimum exigé par les constructeurs seront traitées ensuite. Les fenêtres (83) dans lesquelles la densité de surface est encore supérieure ou égale au minimum exigé par les constructeurs ne nécessitent pas l'insertion de surfaces. La figure 3b montre le résultat obtenu après l'insertion de surfaces factices (95) dans cet exemple de dessin physique d'une couche (X) d'un circuit intégré.

Comme indiqué ci-dessus, le procédé selon l'invention respecte la hiérarchie présente dans le dessin (121) physique du circuit intégré. Les circuits intégrés sont en effet généralement organisés selon une hiérarchie définissant des unités (2) interconnectées et contenant des blocs (30) également interconnectés. Chaque bloc (30) est généralement dessiné selon une méthode particulière, comme, par exemple, la méthode des cellules standard ou la méthode des cellules personnalisées. Chacune des méthodes connues résultent en des dessins très différents, dont la reconnaissance automatique est relativement aisée. Les dessins physiques générés se présentent souvent sous la forme de plusieurs fichiers correspondant soit au dessin d'un bloc et de son routage interne spécifique, soit au dessin d'une unité et de son routage interne entre les blocs, avec des liens appelant les fichiers concernant les blocs contenus dans l'unité, soit au dessin du circuit entier avec son routage entre les unités et des liens appelant les fichiers concernant les unités. La méthode des cellules standards (« standard cell », en anglais) consiste à assembler et interconnecter des cellules (3) provenant d'une bibliothèque de cellules prédéfinies, où chaque cellule correspond à une porte logique. Les cellules sont placées selon des rangées et les interconnexions se font en général dans des canaux situés entre les rangées. La méthode des cellules personnalisées (« custom cell », en anglais) consiste à dessiner des cellules (3) spécialement taillées selon les caractéristiques électriques traitées. Les interconnexions des cellules de ce type se font à l'intérieur de la cellule même. Un bloc (30) d'un circuit intégré correspond souvent à un ensemble fonctionnel capable de réaliser une fonction logique complexe. Il est donc intéressant de pouvoir conserver dans des moyens (120) de mémorisation d'un système (100) de conception des circuits intégrés, des blocs (30) qui auraient été élaborés spécifiquement pour réaliser une tâche donnée et dans lesquels des surfaces factices (95) auraient été insérées en optimisant les performances des blocs (30). Le procédé selon l'invention présente l'avantage de permettre cette conservation, grâce au fait que chacun des éléments constitutifs du circuit intégré sont traités individuellement. Ils peuvent donc être réutilisés indépendamment les uns des autres, avec leurs surfaces factices (95) optimisées, lors de la conception de différents circuits intégrés. De même, dans le cas où un circuit comporte un bloc (30) ou une unité (2) donné(e) répété(e) plusieurs fois dans différentes régions, le procédé permet de ne traiter cet élément qu'une seule fois et de réutiliser le traitement pour toutes les répétitions de cet élément. La modification d'un de ces éléments du circuit est également facilitée puisqu'elle ne nécessitera l'insertion de nouvelles surfaces factices (95) que dans l'élément modifié. D'autre part, le procédé selon l'invention permettant de ne traiter que certains des éléments du circuit, il permettra à plusieurs utilisateurs de réaliser en parallèle le traitement de différentes régions du circuit, de façon à accélérer la procédure d'insertion des surfaces factices pour l'ensemble du circuit intégré.

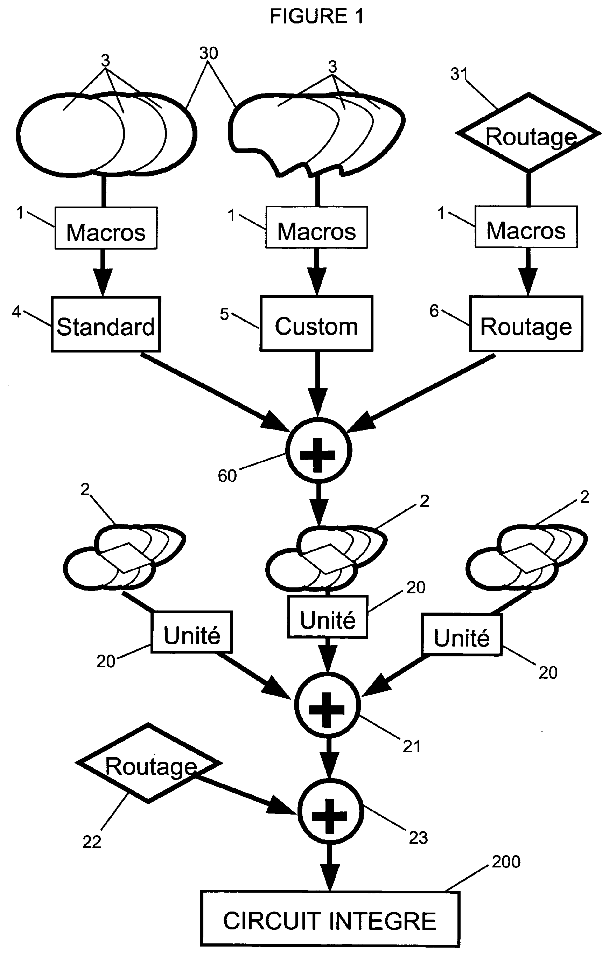

Le procédé selon l'invention consiste en un traitement automatisé du dessin (121) d'un circuit intégré stocké dans les moyens (120) de mémorisation du système de conception de circuits intégrés. Le traitement réalisé sur chacun des blocs (30) est différent selon la méthode qui a été utilisée pour leur dessin, grâce à différentes règles d'insertion de surfaces factices (95), comme indiqué sur la figure 1. Le procédé est sélectif de la méthode de dessin et chacun des blocs (30) de cellules (3) est traité individuellement, soit grâce à l'intervention du concepteur qui définit les blocs et/ou les unités à traiter, soit grâce à des moyens (141) de reconnaissance de la hiérarchie présente dans le dessin (121) des circuits intégrés. Des surfaces factices (95) sont insérées dans le dessin des blocs (30) de cellules (3) « standard » et des blocs (30) de cellules (3) « custom » pour obtenir des motifs (4) de surfaces factices (95) de blocs « standard » et des motifs (5) de surfaces factices (95) de blocs « custom ». Le traitement des zones de routage entre les cellules (3) à l'intérieur des blocs (30) est réalisé lors du traitement des blocs (30). Le traitement du routage (31) entre les blocs (30) est réalisé séparément. Les insertions de surfaces factices (95) dans ces blocs (30) et dans le routage (31) d'interconnexion des blocs se fait par calcul de la densité de surface dans une pluralité de fenêtres (81, 82, 83) de contrôle de densité successives, couvrant l'intégralité de la surface de la couche en cours de traitement dans le dessin (121) du circuit. La taille et la forme des fenêtres de contrôle de densité de surface, dans lesquelles la densité est calculée, sont définies en fonction des fenêtres de contrôle de densité de surfaces utilisées par les constructeurs de semi-conducteurs, stockées dans les moyens (120) de mémorisation du système (100) de conception. Les moyens (131) de calcul de densité du système (100) de conception permettent de déterminer les fenêtres dans lesquelles la densité de surface nécessite l'insertion de surfaces factices (95). Les blocs (30) élaborés par la méthode des cellules standard nécessitent souvent l'insertion de surfaces factices (95) plus petites, moins nombreuses et plus rapprochées que celles à insérer dans les blocs personnalisés. Le routage (31) des liaisons métalliques entre les blocs est traité sélectivement, pour obtenir des motifs (6) de surfaces factices (95) de routage. Les motifs (6) des surfaces factices (95) de routage (31) sont généralement similaires aux liaisons métalliques du routage, mais avec une grande zone d'exclusion, de façon à limiter les risques de couplage entre les surfaces factices (95) et les liaisons métalliques du routage. La combinaison (60) entre eux des motifs (4, 5), obtenus pour les blocs (30) de chaque type de cellules (3) avec les motifs (6) du routage (31), résulte en une unité homogène (20) qui correspond au dessin d'une unité (2) du circuit, avec ses surfaces factices (95) intégrées. Une étape supplémentaire (non représentée) de retrait des surfaces factices (95) se trouvant à la frontière d'une unité (2) donnée et ne respectant pas les zones d'exclusion est ensuite nécessaire. Des moyens (144) de vérification des zones d'exclusion des surfaces factices permettront cette étape de parcours du dessin afin de vérifier l'espacement entre les surfaces et les éléments constitutifs du circuit et permettre la suppression des surfaces factices ne respectant pas ces zones d'exclusion. Ces moyens (144) de vérification des zones d'exclusion mettent en oeuvre, par exemple, une étape de re-dimensionnement des éléments du dessin physique, qui sont provisoirement mis à la taille des zones d'exclusions afin de vérifier la superposition des surfaces factices avec ces éléments re-dimensionnés grâce à une opération booléenne. Lorsqu'une surface factice se superpose avec un élément re-dimensionné, elle est supprimée automatiquement car elle se trouve dans une zone d'exclusion.

Les unités homogènes (20), résultant des combinaisons (60), obtenues pour chacune des unités (2) du circuit, sont ensuite combinées entre elles. Après cette combinaison (21) des unités homogènes (20), l'insertion de surfaces factices (95) dans le routage (22) entre les unités (2) est nécessaire pour compléter le traitement du circuit. En fonction de la taille et de la complexité du circuit intégré, l'insertion des surfaces factices (95) dans le routage entre les unités (2) du circuit peut être réalisé de deux façons différentes. Lorsque le circuit possède une complexité et une taille importantes, il est avantageux de réaliser l'insertion de surfaces factices (95) de routage en ne considérant pas les unités (2) dans le traitement, de façon à réduire le temps de traitement. Grâce à une étape de masquage de zones définies par l'utilisateurs, grâce aux moyens (111) de saisie de commandes, les unités homogènes (20) seront masquées de façon à ne traiter que les liaisons métalliques du routage entre les unités (2) du circuit. Lorsque la complexité et la taille du circuit le permettent, le procédé pourra traiter directement le résultat de la combinaison (21) des unités homogènes (20) pour y insérer des surfaces factices (95) grâce à l'application de fenêtres de densité successives, comme lors du traitement des blocs, en définissant différents motifs de surfaces factices (95) à insérer. Cette possibilité n'est pas représentée sur la figure 1 pour des raisons de clarté. Le motif (22) ainsi obtenu des surfaces factices (95) du routage entre les unités est ajouté au résultat de la combinaison (21) du traitement des unités homogènes (20), grâce à une étape de combinaison (23), représentée sur la figure 1, pour obtenir un motif global (200) des surfaces factices (95) du circuit intégré dans sa totalité.

Grâce à la séparation du traitement des différents éléments du circuit, chaque bloc (30) de cellules (3) ou chaque unité (2) pourra être réutilisé avec ses surfaces factices (95) optimisées dans un circuit intégré différent ou dans une région différente du même circuit, en intégrant son routage interne spécifique. De même, une modification d'un des éléments du circuit ne nécessite le traitement des surfaces factices (95) que de cet élément, puisque ces surfaces factices (95) ont été établies indépendamment des autres éléments du circuit. Le respect de la hiérarchie du dessin (121) et la séparation des différentes étapes permettent que chaque bloc ou unité puisse être traité juste après son élaboration et qu'ils puissent ensuite subir toutes les vérifications de règles de dessin, de preuve formelle, d'étude de timing, etc. en tenant compte de l'existence des surfaces factices (95). Cette séparation des étapes spécifiques de chaque élément du circuit permet également une réduction du temps de traitement nécessaire.

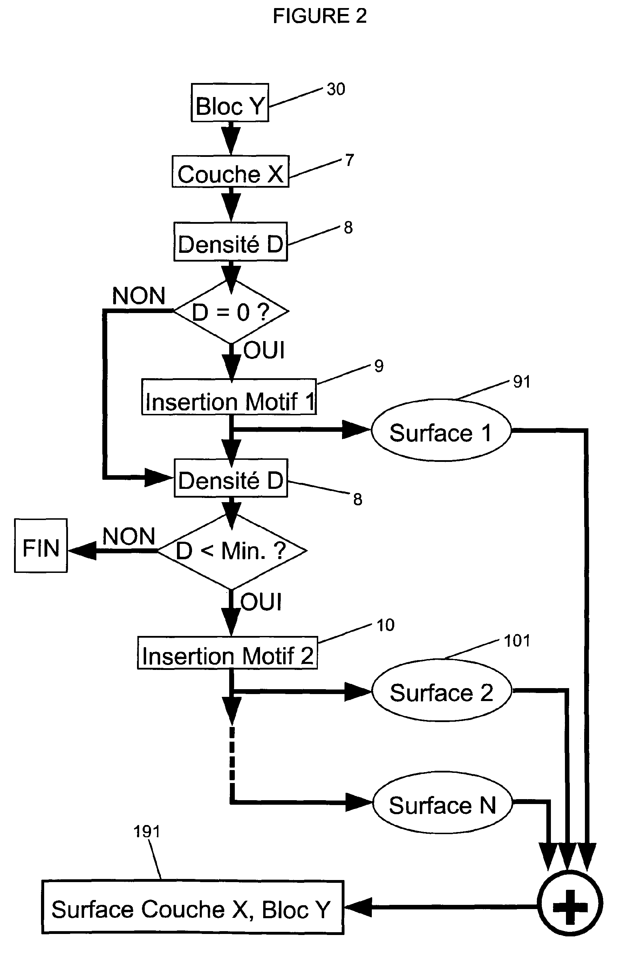

Comme représenté sur la figure 2, quelle que soit la méthode employée pour le dessin des blocs (30) du circuit, le procédé selon l'invention réalise le traitement (7) de chacune des couches du circuit intégré, par un contrôle (8) de la densité de surface dans le dessin, par rapport au seuil de densité minimum exigé par les fabricants de semi-conducteurs. En fonction de la taille et de la forme des fenêtres de contrôle de densité définies par les constructeurs de semi-conducteurs, le procédé réalise le calcul (8) de la densité D dans une pluralité de fenêtres successivement appliquées sur la surface d'une couche donnée X du circuit, grâce aux moyens (131) de calcul de densité du système (100) de conception. En fonction de la densité D calculée pour une fenêtre donnée et de la méthode employée pour dessiner le bloc (30) de cellules (3) correspondant à la fenêtre de densité en cours de traitement, différents motifs de surfaces factices (95) seront insérées. Ces motifs sont déterminés grâce à des moyens (132) de calcul géométrique mis en oeuvre, par exemple, par les macros (1) exécutées par les outils de D.A.O. et représentent la forme et l'arrangement bidimensionnel des surfaces factices (95) à insérer. Les fenêtres de contrôle de densité permettent de ne traiter que les fenêtres dont les densités ne correspondent pas à la densité exigée par les constructeurs, de façon à minimiser le nombre d'éléments ajoutés.

Le procédé selon l'invention répond à une hiérarchie d'insertion des surfaces factices (95), en fonction de la méthode employée pour le dessin des blocs (30) constituant les différents éléments du circuit. Le procédé permet de déterminer les régions du dessin à traiter en priorité, en fonction du calcul (8) de densité D réalisé grâce aux moyens (131) de calcul de densité du système (100) de conception. Les fenêtres traitées en priorité sont celles dont la densité de surface est nulle et le motif inséré est déterminé grâce à l'utilisation de règles de définition des motifs des surfaces factices (95), stockées dans les moyens (120) de mémorisation du système (100) de conception. Le traitement des fenêtres dont la densité est nulle est réalisé par insertion (9) d'un premier motif (91) de surface factice (95) selon la même orientation que celle du routage de la couche X en cours de traitement. Par exemple, le procédé insèrera des rectangles avec une longueur correspondant aux dimensions de la fenêtre de contrôle de densité et une largeur correspondant à la dimension minimum définie par les constructeurs. L'espacement entre les rectangles sera défini de façon à obtenir, dans la fenêtre où la surface factice (95) de ce motif (91) est insérée, une densité légèrement supérieure au minimum exigé par les constructeurs. Après traitement des fenêtres (81) dont la densité D était nulle, le procédé réalise le traitement des fenêtres (82) dont le calcul (8) de la densité a révélé une densité inférieure au minimum (Min.) exigé par les constructeurs. Ce traitement est réalisé par insertion (10) d'un deuxième motif (101) de surface factice (95), similaire aux liaisons métalliques du routage. De façon à limiter les risques de couplage capacitif et donc améliorer les performances du circuit, les surfaces factices (95) de ce motif (101) possèdent de grandes zones d'exclusions et la superposition de ces surfaces factices avec des liaisons métalliques circulant avec la même orientation sur une autre couche est interdite. Cependant, l'arrangement bidimensionnel des cellules (3) du circuit intégré peut parfois poser des problèmes quant au respect complet des différentes contraintes imposées par les constructeurs. Pour pallier à ces éventuels problèmes, le procédé met en oeuvre un ordre de priorité dans le choix des contraintes à imposer parmi ces contraintes de forme, de taille, d'orientation et de zones d'exclusion définissant les motifs des surfaces factices (95) à insérer. Lors du traitement des fenêtres dont la densité D est inférieure au minimum requis, l'ordre de priorité permet de modifier les motifs des surfaces factices (95) grâce aux moyens (132) de calcul géométrique et, si nécessaire, de lever les contraintes, unes à unes, selon l'ordre de priorité suivant : L'ordre de priorité autorisera en premier la superposition des surfaces factices (95) avec des liaisons métalliques circulant avec la même orientation sur une autre couche ; Ensuite, si nécessaire, l'ordre de priorité autorisera l'insertion de surfaces factices (95) avec une orientation perpendiculaire à l'orientation de la couche dans laquelle elles sont insérées ; Si encore nécessaire, l'ordre de priorité autorisera la réduction des zones d'exclusion des surfaces factices (95) insérées selon la même orientation que celle de la couche ; Enfin, si encore nécessaire, l'ordre de priorité autorisera la réduction des zones d'exclusion des surfaces factices (95) insérées selon une orientation perpendiculaire à celle de la couche dans laquelle elles sont insérées. Les zones d'exclusion utilisées lors de la mise en oeuvre du procédé sont initialement prévues pour être plus grande que les zones d'exclusions imposées par les constructeurs, de façon à ce que lorsque le dessin physique oblige à diminuer la taille de certaines zones d'exclusion, elles soient finalement toujours supérieures ou égales aux zones d'exclusion définies par les constructeurs. Le respect de cet ordre de priorité de la levée des contraintes de forme, de taille, d'orientation et de zones d'exclusion des surfaces factices (95) à insérer, permet de minimiser la capacité de couplage entre les surfaces factices (95) ajoutées et les éléments du dessin (121) physique et d'obtenir un circuit intégré dont les performances sont optimisées. Les moyens (140) de traitement du système (100) de conception utilisent cet ordre de priorité stocké dans les moyens (120) de mémorisation du système (100) pour contraindre la détermination sélective des motifs des surfaces factices, établis grâce aux moyens (132) de calcul géométrique.

D'autre part, la hiérarchie d'insertion des surfaces factices est sélective de la méthode employée pour le dessin des blocs (30) du circuit. Les règles de définition des motifs des surfaces factices (95), définissent l'ordre de priorité dans le choix des contraintes des motifs des surfaces factices. Par exemple, pour les régions dessinées grâce à la méthode des cellules standard, ces règles permettent de définir des surfaces factices (95) de petite taille, rapprochées entre elles et avec des zones d'exclusion restreintes. Les surfaces factices (95) insérées étant petites, la hiérarchie d'insertion autorise, selon l'ordre de priorité, la superposition des surfaces factices (95) avec des liaisons métalliques circulant avec la même orientation sur une autre couche. Dans l'exemple du traitement des régions dessinées grâce à la méthode des cellules personnalisées, l'arrangement bidimensionnel des cellules (3) d'une couche donnée et de leur routage nécessite le respect total de l'ordre de priorité énoncé ci-dessus. L'ordre de priorité parmi les contraintes de forme, de taille, d'orientation et de zones d'exclusion des surfaces factices (95) à insérer, devra être respectée rigoureusement, en insérant une grande variété de motifs de surfaces factices (95) adaptées à la place disponible. Un nombre important d'itération des étapes définissant cet ordre de priorité sera donc nécessaire pour obtenir un remplissage optimisé des blocs du circuit dessinés selon la méthode des cellules « custom ».

En fonctionnement, l'algorithme d'insertion des surfaces factices (95) selon l'invention consiste en les étapes énoncées ci-après et représentées sur la figure 2. Pour un bloc Y (30) donné, l'algorithme réalise successivement le traitement (7) de toutes les couches dans lesquelles le bloc Y est inscrit. Dans une couche X donnée, des fenêtres de contrôle de densité sont appliquées successivement pour couvrir l'ensemble de la surface de la couche X contenue dans le bloc Y. Le calcul (8) de la densité D de surface au sein de ces fenêtres permet de déterminer les régions de la couche dans lesquelles des surfaces factices (95) doivent être insérées. L'algorithme selon l'invention commencera par traiter préférentiellement toutes les fenêtres (81) dans lesquelles la densité est nulle, de façon à y insérer (9) des motifs (91) de surfaces factices (95) permettant l'obtention d'une densité de surface légèrement supérieure au minimum exigé par les constructeurs de semi-conducteurs. Si aucune fenêtre à densité nulle n'est trouvée, l'algorithme traitera les fenêtres (82) dans lesquelles la densité est inférieure au minimum exigé par les constructeurs. Des motifs (101) de surfaces factices (95) similaires aux liaisons métalliques de routage, mais avec des zones d'exclusion plus importantes, seront insérées (10) dans ces fenêtres, de façon à obtenir une densité D supérieure au minimum exigé par les constructeurs. Une fois toutes les N fenêtres de contrôle de densité traitées, l'algorithme réalise une combinaison des différents motifs (91, 101) élaborés pour les N fenêtres de densité, pour obtenir un motif (191) des surfaces factices (95) de l'ensemble de la partie de la couche X contenue dans le bloc Y, puis passer au traitement de la couche suivante. Si aucune fenêtre de densité insuffisante n'est trouvée dans la couche X, l'algorithme met fin au traitement de cette couche et procède au traitement de la couche suivante.

L'organisation hiérarchique du procédé selon l'invention permet de respecter la hiérarchie du dessin (121) physique des circuits intégrés. La hiérarchie d'insertion et l'ordre de priorité des contraintes permettent de traiter spécifiquement et sélectivement les différentes régions du dessin, de façon à optimiser les performances du circuit intégré. Ce procédé permet également le traitement de dessins (121) physiques non hiérarchiques grâce à la hiérarchie d'insertion des surfaces factices, qui définit les fenêtres à traiter en priorité selon leur densité. La sélectivité se fera grâce à l'étape de masquage des zones définies par le concepteur. La possibilité de définir différents motifs de surfaces factices (95) à insérer dans les fenêtres grâce à l'utilisation des macros (1) permettra de définir un ensemble de motifs pour chaque région différenciée.

Dans un mode de réalisation de l'invention, le procédé est mis en oeuvre par un outil logiciel de dessin assisté par ordinateur intégrant les différents moyens décrits précédemment. Dans un autre mode de réalisation de l'invention, le procédé est mis en oeuvre par des macros (1) exécutées dans l'environnement logiciel fourni par des outils de D.A.O. classiques. Ces macros (1) permettent la mise en oeuvre des différentes étapes du procédé réalisées grâce aux différents moyens décrits précédemment.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

## Revendications

1. Procédé automatisé d'insertion de surfaces factices (95) dans les différentes couches du dessin (121) physique des circuits intégrés multicouches, organisés en unités (2) interconnectées et contenant des blocs (30) interconnectés et constitués de cellules (3) interconnectées, mis en oeuvre par un système (100) de conception de circuits intégrés, **caractérisé en ce qu'**il consiste en un traitement automatisé, couche par couche, d'un dessin (121) de circuit intégré multicouches stocké dans des moyens (120) de mémorisation du système (100) de conception, par une insertion sélective de motifs de surfaces factices (95) selon une hiérarchie d'insertion respectant la hiérarchie du dessin (121) des circuits intégrés grâce à un traitement individuel des blocs (30) et de leur routage (31) d'interconnexion et un traitement individuel des unités (2) et de leur routage (22) d'interconnexion, les motifs étant établis sélectivement en fonction des méthodes employées pour le dessin des blocs (30) du circuit intégré.

2. Procédé selon la revendication 1, **caractérisé en ce que** les motifs de surfaces factices établis sélectivement, en fonction des méthodes employées pour le dessin des blocs (30) du circuit intégré, sont déterminés grâce à des moyens (132) de calcul géométrique du système (100) de conception et grâce à des règles de définition des motifs des surfaces factices, stockées dans les moyens (120) de mémorisation du système (100) de conception, ces motifs étant définis par une forme, une taille, une orientation et des zones d'exclusion des surfaces factices, ainsi que par un espacement des surfaces factices entre elles.

3. Procédé selon une des revendications 1 et 2, **caractérisé en ce que** l'insertion sélective de motifs de surfaces factices (95), selon une hiérarchie d'insertion respectant la hiérarchie du dessin (121) des circuits intégrés, est réalisée grâce à l'intervention d'un utilisateur, dit concepteur, qui définit, à l'aide de moyens (111) de saisie de commandes du système (100) de conception, les blocs (30) et/ou les unités (2) à traiter dans le dessin (121) du circuit, ainsi que la méthode employée pour le dessin des blocs.

4. Procédé selon une des revendications 1 et 2, **caractérisé en ce que** l'insertion sélective de motifs de surfaces factices (95), selon une hiérarchie d'insertion respectant la hiérarchie du dessin (121) des circuits intégrés, est réalisée de façon automatisée grâce à des moyens (141) de reconnaissance de la hiérarchie du dessin et des moyens (142) de reconnaissance des méthodes de dessin, implémentés dans le système (100) de conception et permettant une définition automatique des blocs (30) et/ou des unités (2) à traiter dans le dessin (121) du circuit, ainsi que de la méthode employée pour leur dessin, au lieu de nécessiter l'intervention de l'utilisateur.

5. Procédé selon une des revendications 1 à 4, **caractérisé en ce qu'**il comporte une étape de détermination de zones à faible densité de surface dans lesquelles des surfaces factices (95) doivent être insérées, réalisée grâce à un calcul (8) de la densité de surface dans chacune des couches du circuit, dans des fenêtres (81, 82, 83) de contrôle de densité dont la forme et les dimensions sont établies selon les fenêtres de contrôle de densité définies par les constructeurs de semi-conducteurs et stockées dans des moyens (120) de mémorisation du système (100) de conception de circuits intégrés, ce calcul étant réalisé par des moyens (131) de calcul de densité implémentés dans le système (100) de conception de circuits intégrés et permettant de ne traiter que les fenêtres (81, 82) dont les densités ne correspondent pas à la densité exigée par les constructeurs et de minimiser le nombre d'éléments ajoutés dans le circuit.

6. Procédé selon une des revendications 1 à 5, **caractérisé en ce que** la hiérarchie d'insertion des surfaces factices, la détermination des zones à faible densité de surface dans lesquelles des surfaces factices (95) doivent être insérées et les règles de définition des motifs des surfaces factices, résultent en un traitement du dessin (121) physique du circuit intégré selon les étapes suivantes :
- insertion de surfaces factices (95) dans les zones à faible densité de surface de chacun des blocs (30) du dessin (121), indépendamment les uns des autres, en fonction de la méthode employée pour leur dessin et leur routage spécifique ;
- traitement du routage (31) entre les blocs (30) et combinaison avec les résultats obtenus pour chaque bloc (30), pour obtenir une unité homogène (20) correspondant au dessin d'une unité (2) avec ses surfaces factices insérées ;
- éventuel retrait des surfaces factices (95) se trouvant à la frontière d'un bloc (30) et ne respectant pas les zones d'exclusion, grâce à des moyens (144) de vérification des zones d'exclusion.
- combinaison (21) entre eux des résultats obtenus pour chacune des unités (2), puis décision, en fonction de la taille et de la complexité du circuit, de l'étape de traitement à réaliser sur le routage (22) entre les unités (2) parmi soit une étape d'insertion de surfaces factices (95) dans les zones à faible densité de surface au sein de la combinaison des unités homogènes, soit une étape d'insertion de surfaces factices (95) dans les zones de routage (22) entre les unités homogènes (20) combinées, grâce à une étape préalable de masquage des zones définies par le concepteur.
- combinaison (23) du résultat des unités homogènes (20) combinées avec le résultat du traitement du routage (22) entre les unités (2), puis éventuel retrait des surfaces factices se trouvant à la frontière d'une unité (2) et ne respectant pas les zones d'exclusion, grâce à des moyens de vérification des zones d'exclusion, pour obtenir un motif (200) de surfaces factices (95) pour le circuit intégré complet.

7. Procédé selon une des revendications 1 à 6, **caractérisé en ce que** la hiérarchie d'insertion des surfaces factices (95) impose que les zones à faible densité de surface traitées en premier correspondent aux fenêtres (81) dont la densité est nulle, les règles de définition des motifs des surfaces factices (95) imposant, dans ces fenêtres (81) à densité nulle, l'insertion de surfaces factices (95) selon la même orientation que celle du routage de la couche en cours de traitement, avec une dimension maximum correspondant aux dimensions de la fenêtre de contrôle de densité, une dimension minimum correspondant à la dimension minimum définie par les constructeurs et un espacement entre les surfaces défini de façon à obtenir une densité légèrement supérieure au minimum exigé par les constructeurs.

8. Procédé selon une des revendications 1 à 7, **caractérisé en ce que** la hiérarchie d'insertion des surfaces factices (95) impose que les zones à faible densité de surface traitées en second correspondent aux fenêtres (82) dont la densité est encore inférieure au minimum exigé par les constructeurs, les règles de définition des motifs des surfaces factices (95) imposant, dans ces fenêtres (82) à densité insuffisante, l'insertion de surfaces factices (95) similaires aux liaisons métalliques du routage, avec une grande zone d'exclusion, en interdisant la superposition des surfaces factices avec des liaisons métalliques circulant avec la même orientation sur une autre couche.

9. Procédé selon une des revendications 1 à 8, **caractérisé en ce que** les règles de définition des motifs des surfaces (95) factices comportent un ordre de priorité dans le choix des contraintes à imposer à ces motifs parmi les contraintes de forme, de taille, d'orientation et des zones d'exclusion des surfaces factices à insérer, cet ordre de priorité étant mémorisé dans les moyens (120) de mémorisation du système (100) de conception de circuits intégrés et permettant d'autoriser, si nécessaire, la levée des contraintes, unes à unes, selon les étapes suivantes dont les itérations permettent de définir les motifs des surfaces factices à insérer :
- autorisation de la superposition des surfaces factices avec des liaisons métalliques circulant avec la même orientation sur une autre couche ;
- autorisation de l'insertion de surfaces factices avec une orientation perpendiculaire à l'orientation de la couche dans laquelle elles sont insérées ;
- autorisation de la réduction des zones d'exclusion des surfaces factices insérées selon la même orientation que celle de la couche ;
- autorisation de la réduction des zones d'exclusion des surfaces factices insérées selon une orientation perpendiculaire à celle de la couche dans laquelle elles sont insérées.

10. Procédé selon une des revendications 1 à 9, **caractérisé en ce que** l'insertion sélective des motifs des surfaces factices (95), en fonction de la méthode employée pour le dessin des blocs (30) et les règles de définition des motifs des surfaces factices (95) permettent, pour les régions dessinées avec des cellules (3) standard, de définir des surfaces factices (95) de petite taille, rapprochées entre elles et avec des zones d'exclusion restreintes et d'autoriser la superposition des surfaces factices avec des liaisons métalliques circulant avec la même orientation sur une autre couche, le traitement des régions dessinées avec des cellules (3) personnalisées nécessitant le respect complet de l'ordre de priorité dans le choix des contraintes à imposer, avec une itération importante des étapes définissant l'ordre de priorité des contraintes, résultant en une grande variété de motifs des surfaces factices (95).

11. Procédé selon une des revendications 1 à 10, **caractérisé en ce qu'**il permet le traitement de dessins (121) physiques non hiérarchiques grâce la détermination de des fenêtres (81, 82) à traiter en priorité selon leur densité, grâce aux règles de définition des motifs des surfaces factices (95) à insérer et éventuellement grâce à l'étape de masquage de zones définies par le concepteur.

12. Procédé selon une des revendications 1 à 11, **caractérisé en ce qu'**il est mis en oeuvre par l'exécution, par le système (100) de conception de circuits intégrés, d'un outil logiciel de dessin assisté par ordinateur exécutant des macros (1) permettant les itérations des différentes étapes du procédé, résultant en la définition sélective des motifs des surfaces factices (95) et leur insertion dans les couches successives du circuit intégré.

13. Procédé selon une des revendications 1 à 12, **caractérisé en ce que** les zones d'exclusion des surfaces factices (95) utilisées lors de la mise en oeuvre du procédé ont des dimensions supérieures à celles définies par les constructeurs, de façon à ce que lorsque les contraintes de taille des zones d'exclusion sont toutes levées, les zones d'exclusion obtenues restent de taille supérieure ou égale à la taille des zones d'exclusion définies par les constructeurs.

14. Procédé selon une des revendications 1 à 13, **caractérisé en ce qu'**il peut être limité par l'utilisateur de façon à ne traiter que certains blocs (30) ou que certaines unités (2), pour permettre le traitement en parallèle de différentes portions du circuit dans plusieurs systèmes (100) de conception de circuits intégrés, afin d'accélérer le traitement du dessin (121) complet du circuit, le traitement séparé des blocs (30) et/ou des unités (2) permettant une modification ultérieure sélective de ces éléments du circuit individuellement et leur éventuelle réutilisation dans le cas de la présence d'un élément identique dans une autre région du circuit ou dans un autre circuit intégré.

15. Système (100) de conception de circuits intégrés permettant la mise en oeuvre du procédé selon l'invention grâce à l'exécution de macros (1) dans des outils logiciels de dessin assisté par ordinateur et comportant des moyens (110) d'affichage et des moyens (111) de saisie de commandes par l'utilisateur, **caractérisé en ce qu'**il comporte des moyens (120) de mémorisation, des moyens (130) de calcul, des moyens (140) de traitement et des moyens (144) de vérification des zones d'exclusion.

16. Système (100) de conception de circuits intégrés selon la revendication 15, **caractérisé en ce que** les moyens (130) de calcul comportent, en outre, des moyens(131) de calcul de densité et des moyens (132) de calcul géométrique.

17. Système (100) de conception de circuits intégrés selon une des revendications 15 et 16, **caractérisé en ce que** les moyens (120) de mémorisation contiennent, en outre, des informations concernant le dessin (121) physique du circuit intégré dans lequel les surfaces factices (95) doivent être insérées, la forme et les dimensions des fenêtres (81, 82, 83) de contrôle de densité définies par les constructeurs de semi-conducteurs, les règles de définition des motifs des surfaces factices (95) permettant la définition des motifs de surfaces factices (95) selon les densité de surface des différentes fenêtres (81, 82, 83), les différentes méthodes de dessin des blocs (30) constituant les circuits intégrés et l'ordre de priorité défini par le concepteur du circuit intégré pour le choix des contraintes à imposer aux motifs des surfaces factices (95) à insérer, toutes ces informations étant accessibles aux moyens (140) de traitement du système (100) de conception de circuits intégrés pour les prendre en compte lors de l'exécution des macros (1) permettant la définition des motifs des surfaces factices (95) et leur insertion dans les couches successives du circuit intégré.

18. Système (100) de conception de circuits intégrés selon une des revendications 15 à 17, **caractérisé en ce qu'**il comporte également des moyens (141) de reconnaissance de la hiérarchie du dessin et des moyens (142) de reconnaissance des méthodes de dessin, de façon à ce que la définition des blocs (30) et/ou des unités (2) à traiter dans le dessin (121) du circuit, ainsi que de la méthode employée pour leur dessin soit réalisée de façon automatisée par le système (100) sans nécessiter l'intervention de l'utilisateur.
